# EUROPEAN PATENT APPLICATION

(11) **EP 4 465 338 A1**
(43) Date of publication of application: **20.11.2024**
(21) Application number: 22920426.8
(22) Date of filing: 28.10.2022
(51) Int. Cl.: H01L 21/02, G05B 19/418, G05B 23/02

(54) **SUBSTRATE PROCESSING DEVICE MANAGEMENT SYSTEM, SUBSTRATE PROCESSING DEVICE MANAGEMENT METHOD, AND SUBSTRATE PROCESSING DEVICE MANAGEMENT PROGRAM**

(30) Priority: 11.01.2022 JP 2022002650
(71) Applicant: SCREEN Holdings Co., Ltd., Kyoto-shi, Kyoto 602-8585 (JP)
(72) Inventor: MATSUI, Hiroakira, Kyoto-shi, Kyoto 602-8585 (JP); SEIWA, Takaaki, Kyoto-shi, Kyoto 602-8585 (JP); INAGI, Dai, Kyoto-shi, Kyoto 602-8585 (JP); UENO, Tomohiro, Kyoto-shi, Kyoto 602-8585 (JP); NAKANO, Yuta, Kyoto-shi, Kyoto 602-8585 (JP); YOSHIHARA, Koki, Kyoto-shi, Kyoto 602-8585 (JP); ONO, Takuya, Kyoto-shi, Kyoto 602-8585 (JP)
(74) Representative: Kilian Kilian & Partner mbB
(86) International application number: PCT/JP2022/040548
(87) International publication number: WO 2023/135904

(57) **Abstract**

In a substrate processing apparatus management system, a plurality of processing information pieces representing operations or states relating to a process for a substrate are collected from each of a plurality of substrate processing apparatuses. In regard to each substrate processing apparatus, a degree of abnormality of the substrate processing apparatus is calculated as an abnormality score based on a plurality of processing information pieces collected from the substrate processing apparatus and invariant relationships in regard to a plurality of processing information pieces. A management device accepts an inspection request in regard to an abnormality transmitted from each substrate processing apparatus. When two or more inspection requests are accepted, the abnormality scores of the substrate processing apparatuses corresponding to these inspection requests are acquired. Based on the plurality of acquired abnormality scores, priority order information relating to the priority order for two or more inspection requests to be responded is presented to an administrator.

## Description

### [Technical Field]

The present invention relates to a substrate processing apparatus management system, a substrate processing apparatus management method and a substrate processing apparatus management program that are used for management of a plurality of substrate processing apparatuses.

### [Background Art]

A substrate processing device is used to execute various processes on various substrates such as a substrate for an FPD (Flat Panel Display) that is used for a liquid crystal display device, an organic EL (Electro Luminescence) display device or the like, a semiconductor substrate, a substrate for an optical disc, a substrate for a magnetic disc, a substrate for a magneto-optical disc, a substrate for a photomask, a ceramic substrate or a substrate for a solar cell. In the substrate processing apparatus, a series of processes is executed on a substrate in accordance with a predetermined processing procedure (recipe), for example. In order to prevent an occurrence of a processing defect in a substrate due to an abnormality present in a substrate processing apparatus, a data processing system for determination in regard to an abnormality in the substrate processing apparatus has been proposed (see Patent Document 1, for example).

In the data processing system, a plurality of physical quantities related to a substrate processing apparatus are measured during a process for a substrate, and these measurement results are arranged in a chronological order, so that a plurality of time-series data pieces are generated. The plurality of time-series data pieces include data of the physical quantities such as a flow rate of a processing liquid discharged from a nozzle and a pressure in a chamber, for example. Each time-series data piece is compared with predetermined reference data, so that an evaluation value is calculated. It is determined whether an abnormality is present in the time-series data piece based on the calculated evaluation value.
[Patent Document 1] JP 2020-47847 A

### [Summary of Invention]

### [Technical Problem]

A plurality of substrate processing apparatuses are respectively installed in a plurality of places in the world, for example. A maintenance work for each substrate processing apparatus is performed by a maintenance worker, on site, who is in charge of the substrate processing apparatus. The maintenance worker can recognize whether an abnormality has occurred in the substrate processing apparatus based on an abnormality determination result provided by the above-mentioned data processing system.

When an abnormality occurs in the substrate processing apparatus, the maintenance worker may not be able to identify the cause of the abnormality. In this case, the maintenance worker requests an administrator who manages a plurality of substrate processing apparatuses to inspect the substrate processing apparatus, which the maintenance worker is in charge of, in detail. The administrator who has received the inspection request performs various inspections in regard to the substrate processing apparatus to be inspected. Further, the administrator provides a specific work instruction based on an inspection result to the maintenance worker has made an inspection request.

When a plurality of inspection requests are made in regard to a plurality of substrate processing apparatus from a plurality of maintenance workers, it is difficult for the administrator to inspect the plurality of substrate processing apparatuses in parallel. In this case, the administrator determines the inspection priority order in regard to the plurality of substrate processing apparatuses. In order to appropriately determine the inspection priority order, it is necessary to recognize a degree of abnormality of the plurality of substrate processing apparatuses to be inspected. In order to recognize the degree of abnormality of the plurality of substrate processing apparatuses, primary inspection must be performed in regard to the plurality of substrate processing apparatuses. This primary inspection includes an analysis of past time-series data and an interview with a maintenance worker, for example. In this manner, the primary inspection is complicated. Therefore, after receiving a plurality of inspection requests, the administrator requires a long period of time to start the actual inspection in regard to each inspection request.

An object of the present invention is to provide a substrate processing apparatus management system, a substrate processing apparatus management method and a substrate processing apparatus management program which enable an administrator to easily and appropriately recognize an inspection priority order in a short period of time in a case in which a plurality of inspection requests are made in regard to a plurality of substrate processing apparatuses.

### [Solution to Problem]

(1) A substrate processing apparatus management system according to one aspect of the present invention that is used to manage a plurality of substrate processing apparatuses, includes an information collector that collects a plurality of processing information pieces representing operations or states relating to a process for a substrate from each substrate processing apparatus, a score calculator that, in regard to each substrate processing apparatus, calculates a degree of abnormality of the substrate processing apparatus as an abnormality score based on a plurality of processing information pieces collected from the substrate processing apparatus and invariant relationships in regard to the plurality of substrate processing information pieces, a request acceptor that accepts an inspection request in regard to an abnormality from each substrate processing apparatus, a score acquirer that acquires two or more abnormality scores respectively calculated in regard to two or more substrate processing apparatuses that have transmitted inspection requests to the request acceptor, and a priority order presenter that, based on the two or more abnormality scores acquired by the score acquirer, presents priority order information relating to priority order for the two or more inspection requests to be responded.
   In the substrate processing apparatus management system, in regard to each of the plurality of substrate processing apparatuses, a degree of abnormality of the substrate processing apparatus is calculated as an abnormality score. In a case in which the two or more inspection requests are made in regard to the two or more substrate processing apparatuses, the priority order information based on the abnormality scores of the two or more substrate processing apparatuses which have transmitted the inspection requests are presented. An abnormality score is calculated based on the invariant relationships in regard to a plurality of processing information pieces. Therefore, in regard to a plurality of substrate processing apparatuses that have transmitted inspection requests, the administrator of the plurality of substrate processing apparatuses can easily and appropriately recognize the inspection priority order.
(2) The priority order presenter may present the two or more respective abnormality scores acquired by the score acquirer in association with the two or more respective substrate processing apparatuses. In this case, based on the presented abnormality scores, the administrator of the plurality of substrate processing apparatuses can easily recognize the degrees of abnormality of the two or more substrate processing apparatuses that have transmitted inspection requests.
(3) The substrate processing apparatus management system may further include a score transmitter that transmits an abnormality score calculated by the score calculator to a substrate processing apparatus corresponding to the abnormality score. In this case, an abnormality score can be stored in each substrate processing apparatus. Thus, in each substrate processing apparatus, it is possible to analyze an abnormality based on the abnormality score.
(4) The substrate processing apparatus management system may further include a warning transmitter that determines whether an abnormality score calculated in regard to each substrate processing apparatus exceeds a predetermined threshold value, and in a case in which the abnormality score exceeds the threshold value, transmits a warning to a substrate processing apparatus corresponding to the abnormality score. In this case, it is possible to easily recognize an occurrence of an abnormality exceeding a predetermined degree in each substrate processing apparatus.
(5) The information collector may repeat integration and reset of a plurality of processing information pieces that are calculated each time a certain period of time elapses, and the score calculator, in regard to each substrate processing apparatus, may calculate a degree of abnormality of the substrate processing apparatus as the abnormality score based on a plurality of processing information pieces that are generated by the substrate processing apparatus and integrated by the information collector and invariant relationships in regard to the plurality of processing information pieces. In this case, it suppresses the influence of a noise or the like generated when each processing information piece is collected on an abnormality score.
(6) In regard to the plurality of processing information pieces, a plurality of combinations each of which includes two different processing information pieces may be defined, each combination may include a first processing information piece and a second information piece, and the score calculator, in regard to each combination, may generate, based on the second processing information piece that is collected under a predetermined condition, the first processing information piece that is predicted under the predetermined condition as a first prediction processing information piece, and may calculate a degree of deviation between the generated first prediction processing information piece and the first processing information piece actually collected by the data collector as a first deviation degree, in regard to each combination, may generate, based on the first processing information piece that is collected under the predetermined condition, the second processing information that is predicted under the predetermined condition as a second prediction processing information piece, and may calculate a degree of deviation between the generated second prediction processing information piece and the second processing information piece that is actually collected by the data collector as a second deviation degree, and may calculate the abnormality score based on a plurality of first deviation degrees and a plurality of second deviation degrees that are respectively calculated in regard to the plurality of combinations. In this case, it is possible to calculate an abnormality score in regard to each actually calculated processing information piece based on the invariant relationship with another processing information piece.
(7) The score calculator may calculate a sum of the plurality of first deviation degrees and the plurality of second deviation degrees that are respectively calculated in regard to the plurality of combinations as the abnormality score. In this case, it is possible to easily calculate a degree of abnormality of each substrate processing apparatus.
(8) A predetermined weight may be assigned to each of the plurality of combinations according to relevance of the combination to a plurality of types of abnormal states of a substrate processing apparatus, and the score calculator may calculate the plurality of first deviation degrees and the plurality of second deviation degrees based on the plurality of combinations and the plurality of weights.
   In this case, it is possible to more appropriately recognize a degree of abnormality of each substrate processing apparatus by referring to an abnormality score calculated based on the plurality of first deviation degrees and the plurality of second deviation degrees.
(9) The plurality of processing information pieces may include at least one physical quantity among an amount of fluid supplied to a substrate, a temperature of fluid supplied to the substrate, a concentration of a processing liquid supplied to the substrate, a temperature in a processing chamber in which the substrate is accommodated, a pressure in the processing chamber in which the substrate is accommodated, a pressure of gas exhausted from the processing chamber in which the substrate is accommodated and a moving speed of the substrate transported by a robot. In this case, an abnormality score is calculated based on one or a plurality of physical quantities acquired in a substrate processing apparatus.
(10) The plurality of processing information pieces may include information relating to at least one of a drive pulse signal that drives a robot transporting a substrate, an output signal of a detector provided in the robot transporting the substrate and an open-close signal provided to a control valve. In this case, an abnormality score is calculated based on one or a plurality of signals used in a substrate processing apparatus.
(11) Each substrate processing apparatus may be a substrate cleaning device that cleans a substrate using a cleaning liquid, and the plurality of processing information pieces may include at least one of a supply amount of the cleaning liquid supplied to the substrate, a temperature of the cleaning liquid supplied to the substrate and a concentration of the cleaning liquid supplied to the substrate. In this case, in a case in which a plurality of inspection requests are made in regard to a plurality of substrate cleaning devices, the inspection priority order is appropriately determined.
(12) A substrate processing apparatus management method according to another aspect of the present invention that is used for management of a plurality of substrate processing apparatuses, includes the steps of collecting a plurality of processing information pieces representing operations or states relating to a process for a substrate from each substrate processing apparatus, in regard to each substrate processing apparatus, calculating a degree of abnormality of the substrate processing apparatus as an abnormality score based on a plurality of processing information pieces collected from the substrate processing apparatus and invariant relationships in regard to the plurality of substrate processing apparatuses, accepting an inspection request in regard to an abnormality from each substrate processing apparatus, acquiring two or more abnormality scores respectively calculated in regard to two or more substrate processing apparatuses that have transmitted inspection requests, and based on the two or more abnormality scores acquired by the score acquirer, presenting priority order information relating to priority order for the two or more inspection requests to be responded.
   With the substrate processing apparatus management method, in regard to each of a plurality of substrate processing apparatuses, a degree of abnormality of the substrate processing apparatus is calculated as an abnormality score. In a case in which two or more inspection requests are made in regard to two or more substrate processing apparatuses, the priority order information based on the abnormality scores of the two or more substrate processing apparatuses which have transmitted the inspection requests are presented. An abnormality score is calculated based on the invariant relationships in regard to a plurality of processing information pieces. Therefore, in regard to a plurality of substrate processing apparatuses that have transmitted inspection requests, the administrator of the plurality of substrate processing apparatuses can easily and appropriately recognize the inspection priority order.
(13) A substrate processing apparatus management program according to yet another aspect of the present invention for causing a computer to execute a process of managing a plurality of substrate processing apparatuses using an information analysis device, wherein the information analysis device includes an information collector that collects a plurality of processing information pieces representing operations or states relating to a process for a substrate from each substrate processing apparatus, and a score calculator that, in regard to each substrate processing apparatus, calculates a degree of abnormality of the substrate processing apparatus as an abnormality score based on a plurality of processing information pieces collected from the substrate processing apparatus and invariant relationships in regard to the plurality of processing information pieces, and the process of managing a plurality of substrate processing apparatuses includes accepting an inspection request in regard to an abnormality from each substrate processing apparatus, acquiring two or more abnormality scores respectively calculated in regard to two or more substrate processing apparatuses that have transmitted inspection requests, and based on the two or more abnormality scores acquired by the acquiring, presenting priority order information relating to priority order for the two or more inspection requests to be responded.

With the substrate processing apparatus management program, in a case in which two or more inspection requests have been made in regard to two or more substrate processing apparatuses, the priority order information based on the abnormality scores of the two or more substrate processing apparatuses that have transmitted the inspection requests are presented. An abnormality score is calculated based on the invariant relationships in regard to a plurality of processing information pieces. Therefore, in regard to a plurality of substrate processing apparatuses that have transmitted inspection requests, the administrator of the plurality of substrate processing apparatuses can easily and appropriately recognize the inspection priority order.

### [Advantageous Effects of Invention]

With the present invention, in a case in which a plurality of inspection requests are made in regard to a plurality of substrate processing apparatuses, an administrator can easily and appropriately recognize the inspection priority order in a short period of time.

### [Brief Description of the Drawings]

[FIG. 1] Fig. 1 is a diagram for explaining the configuration of a substrate processing apparatus management system according to a first embodiment.
[FIG. 2] Fig. 2 is a block diagram for explaining the functional configuration of the substrate processing apparatus management system according to the first embodiment.
[FIG. 3] Fig. 3 is a diagram for explaining the specific example of calculation of deviation degrees.
[FIG. 4] Fig. 4 is a diagram for explaining the specific example of calculation of an abnormality score.
[FIG. 5] Fig. 5 is a flowchart showing one example of a process executed in each of a plurality of substrate processing apparatuses of Fig. 1.
[FIG. 6] Fig. 6 is a flowchart showing one example of a process executed in an information analysis device of Fig. 1.
[FIG. 7] Fig. 7 is a flowchart showing one example of a process executed in a management device of Fig. 1.
[FIG. 8] Fig. 8 is a diagram for explaining the functional configuration of a substrate processing apparatus management system according to a second embodiment.
[FIG. 9] Fig. 9 is a diagram showing one example of a plurality of weights stored in a weight storage of Fig. 8.

### [Description of Embodiments]

A substrate processing apparatus management system, a substrate processing apparatus management method and a substrate processing apparatus management program according to one embodiment of the present invention will be described below with reference to the drawings. In the following description, a substrate refers to a semiconductor substrate, a substrate for an FPD (Flat Panel Display) such as a liquid crystal display device or an organic EL (Electro Luminescence) display device, a substrate for an optical disc, a substrate for a magnetic disc, a substrate for a magneto-optical disc, a substrate for a photomask, a ceramic substrate, a substrate for a solar battery, or the like.

### 1. First Embodiment

### <1> Configuration and Operation of Substrate Processing Apparatus Management System

### (1) Overall Configuration

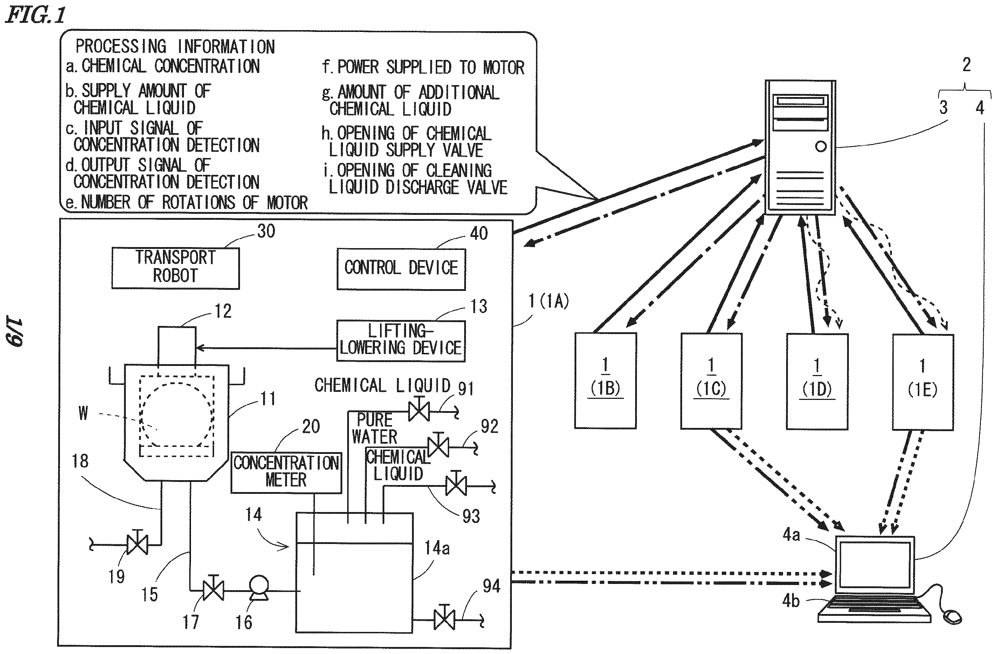

Fig. 1 is a diagram for explaining the configuration of the substrate processing apparatus management system according to a first embodiment. As shown in Fig. 1, the substrate processing apparatus management system 2 according to the present embodiment mainly includes an information analysis device 3 and a management device 4, and is used to manage one or a plurality (five in the present example) of substrate processing apparatuses 1. In the following description, in a case in which the five substrate processing apparatuses 1 shown in Fig. 1 are distinguished from one another, the five substrate processing apparatuses 1 are respectively referred to as the substrate processing apparatuses 1A, 1B, 1C, 1D, 1E. In the present embodiment, the substrate processing apparatuses 1A to 1E have the same configuration.

### (2) One Example of Configuration of Substrate Processing Apparatus 1A

As shown in Fig. 1, the substrate processing apparatus 1A is a so-called batchtype substrate cleaning apparatus, and includes a processing bath 11, a substrate holder 12, a lifting-lowering device 13, a cleaning liquid generation device 14, a concentration meter 20, a transport robot 30 and a control device 40. In the substrate processing apparatus 1A, a display device, a speech output device and an operation unit (not shown) are provided in addition to the plurality of above-mentioned constituent elements.

The substrate holder 12 is configured to be capable of holding a plurality of substrates W. The processing bath 11 is configured to be capable of accommodating the plurality of substrates W held by the substrate holder 12. A cleaning liquid for cleaning the substrate W is stored in the processing bath 11.

The lifting-lowering device 13 supports the substrate holder 12 to be movable in an upward-and-downward direction and moves the substrate holder 12 in the upward-and-downward direction with the control of the control device 40. Thus, the lifting-lowering device 13 can immerse the plurality of substrates W held by the substrate holder 12 in the cleaning liquid stored in the processing bath 11, and can pull up the plurality of substrates W immersed in the cleaning liquid from the processing bath 11. The plurality of substrates W are cleaned by being immersed in the cleaning liquid. Further, in the lifting-lowering device 13, a motor (not shown) as a power source for moving the substrate holder 12 in the upward-and-downward direction is provided.

The cleaning liquid generation device 14 includes a storage tank 14a and a stirring device (a bubbling device or the like) (not shown). A chemical liquid supply pipe 91, a pure water supply pipe 92, an additional chemical liquid supply pipe 93 and a liquid drain pipe 94 are connected to the storage tank 14a. A valve is provided in each of the plurality of pipes (91 to 94). Each valve is a control valve the opening of which is adjustable by the control of the control device 40.

The chemical liquid supply pipe 91 guides a chemical liquid supplied from a chemical liquid supply system (not shown) to the storage tank 14a when the valve provided in the chemical liquid supply pipe 91 is opened. The flow rate (the supply amount per unit time) of the chemical liquid supplied to the storage tank 14a through the chemical liquid supply pipe 91 changes according to the opening of the valve provided in the chemical liquid supply pipe 91.

The pure water supply pipe 92 guides a pure water supplied from a pure water supply system (not shown) to the storage tank 14a when the valve provided in the pure water supply pipe 92 is opened. The flow rate (the supply amount per unit time) of the pure water supplied to the storage tank 14a through the pure water supply pipe 92 changes according to the opening of the valve provided in the pure water supply pipe 92.

In this manner, the predetermined amounts of the chemical liquid and the pure water are stored in the storage tank 14a of the cleaning liquid generation device 14. Further, in the storage tank 14a, the chemical liquid and the pure water stored therein are mixed by a stirring mechanism (not shown), and a cleaning liquid to be stored in the processing bath 11 is generated. As the chemical liquid, BHF (Buffered Hydrofluoric Acid), DHF (Dilute Hydrofluoric Acid), hydrofluoric acid, hydrochloric acid, sulfuric acid, nitric acid, phosphoric acid, acetic acid, oxalic acid, ammonia, or the like is used.

The additional chemical liquid supply pipe 93 guides a chemical liquid supplied from the chemical liquid supply system (not shown) to the storage tank 14a when the valve provided in the chemical liquid supply pipe 91 is opened. The supply of the chemical liquid to the storage tank 14a through the additional chemical liquid supply pipe 93 will be described below. The liquid drain pipe 94 discharges some or all of the cleaning liquid stored in the cleaning liquid generation device 14 to the outside of the substrate processing apparatus 1A when the valve provided in the liquid drain pipe 94 is opened.

A liquid supply pipe 15 is further connected to the storage tank 14a. The liquid supply pipe 15 is provided so as to connect the processing bath 11 and the cleaning liquid generation device 14 to each other. Further, a pump 16 and a valve 17 are provided in the liquid supply pipe 15. The valve 17 is a control valve the opening of which is adjustable by the control of the control device 40. When the valve 17 is opened during the operation of the pump 16, the cleaning liquid stored in the storage tank 14a is supplied into the processing bath 11. The flow rate (the supply amount per unit time) of the cleaning liquid supplied to the processing bath 11 from the storage tank 14a changes according to the opening of the valve 17.

A liquid discharge pipe 18 is connected to a bottom portion of the processing bath 11. A valve 19 is provided in the liquid discharge pipe 18. The valve 19 is a control valve the opening of which is adjustable by the control of the control device 40. When the valve 19 is opened, some of the cleaning liquid stored in the processing bath 11 is discharged from the substrate processing apparatus 1A through the liquid discharge pipe 18. The flow rate (the supply amount per unit time) of the cleaning liquid discharged from the processing bath 11 changes according to the opening of the valve 19. During a cleaning process for a plurality of substrates W, the cleaning liquid is supplied from the cleaning liquid generation device 14 to the processing bath 11, and the cleaning liquid in the processing bath 11 is discharged through the liquid discharge pipe 18.

The concentration meter 20 detects the chemical concentration in the cleaning liquid stored in the storage tank 14a in response to an instruction provided by the control device 40, and provides a detection result to the control device 40. The transport robot 30 transports the plurality of substrates W held by the substrate holder 12 at a position farther upward than the processing bath 11. The control device 40 includes a CPU (Central Processing Unit) and a memory, for example, and controls an operation of the lifting-lowering device 13, an operation of the transport robot 30, openings of the valves 17, 19, and the like. The memory of the control device 40 stores a first management program, described below.

Further, based on a detection result of the chemical concentration provided by the concentration meter 20, the control device 40 performs feedback control of an amount of the chemical liquid supplied to the storage tank 14a such that the chemical concentration of the cleaning liquid stored in the storage tank 14a is within a predetermined range. For example, in a case in which the chemical concentration of the cleaning liquid detected by the concentration meter 20 is lower than a predetermined range, the control device 40 supplies an additional chemical liquid from a chemical liquid supply system (not shown) to the cleaning liquid generation device 14 through the additional chemical liquid supply pipe 93.

Further, the control device 40 has an emergency shutdown function for stopping an operation of the substrate processing apparatus 1A in a case in which a person enters a predetermined space inside of the substrate processing apparatus 1A or a predetermined detector (the concentration meter 20, for example) provided in the substrate processing apparatus 1A is not functioning.

### (3) Processing Information

In each substrate processing apparatus 1, as information for management of an abnormality of the substrate processing apparatus 1, a plurality of processing information pieces representing the operations or states relating to a process for the substrate W in the substrate processing apparatus 1 are defined. As indicated by the thick solid arrows in Fig. 1, these processing information pieces are transmitted from the control device 40 of each substrate processing apparatus 1 to the information analysis device 3 of the substrate processing apparatus management system 2 in a predetermined period.

As shown in the balloon of Fig. 1, the processing information pieces transmitted from the substrate processing apparatus 1A to the information analysis device 3 include "a. CHEMICAL CONCENTRATION," "b. SUPPLY AMOUNT OF CHEMICAL LIQUID," "c. INPUT SIGNAL OF CONCENTRATION DETECTION," "d. OUTPUT SIGNAL OF CONCENTRATION DETECTION," "e. NUMBER OF ROTATIONS OF MOTOR," "f. POWER SUPPLIED TO MOTOR," "g. AMOUNT OF ADDITIONAL CHEMICAL LIQUID," "h. OPENING OF CHEMICAL LIQUID SUPPLY VALVE" and "i. OPENING OF CLEANING LIQUID DISCHARGE VALVE."

"a. CHEMICAL CONCENTRATION" indicates a chemical concentration in the cleaning liquid in the storage tank 14a detected by the concentration meter 20. "b. SUPPLY AMOUNT OF CHEMICAL LIQUID" indicates a flow rate (supply amount per unit time) of the cleaning liquid supplied from the chemical liquid supply pipe 91 to the storage tank of the cleaning liquid generation device 14. "b. SUPPLY AMOUNT OF CHEMICAL LIQUID" can be detected by provision of a flowmeter in the chemical liquid supply pipe 91, for example.

In the substrate processing apparatus 1A, the control device 40 instructs the concentration meter 20 to detect a concentration, so that the chemical concentration of the cleaning liquid is detected. "c. INPUT SIGNAL OF CONCENTRATION DETECTION" is an instruction signal for detection of concentration provided from the control device 40 to the concentration meter 20. "d. OUTPUT SIGNAL OF CONCENTRATION DETECTION" is a signal indicating a detection result of chemical concentration output from the concentration meter 20 in response to an instruction provided by the control device 40.

"e. NUMBER OF ROTATIONS OF MOTOR" is the number of rotations of motor provided in the lifting-lowering device 13 and can be calculated by detection of the rotation speed of the motor using a rotation speed sensor, for example. "f. POWER SUPPLIED TO MOTOR" is an amount of power supplied to the motor provided in the lifting-lowering device 13 and can be calculated by detection of a current supplied to the motor using an ammeter, for example.

"g. AMOUNT OF ADDITIONAL CHEMICAL LIQUID" indicates a supply amount per unit time of a chemical liquid additionally supplied from the additional chemical liquid supply pipe 93 to the storage tank 14a such that the chemical concentration of the cleaning liquid stored in the storage tank 14a is in a predetermined range. "g. AMOUNT OF ADDITIONAL CHEMICAL LIQUID" can be detected by provision of a flowmeter in the additional chemical liquid supply pipe 93, for example. "h. OPENING OF CHEMICAL LIQUID SUPPLY VALVE" indicates an opening of the valve provided in the chemical liquid supply pipe 91. "i. OPENING OF CHEMICAL LIQUID DISCHARGE VALVE" indicates an opening of the valve provided in the liquid drain pipe 94.

### (4) Basic Operation in Information Analysis Device 3

The information analysis device 3 is a server, for example, and includes a CPU and a memory. The information analysis device 3 collects a plurality of processing information pieces transmitted from each substrate processing apparatus 1. In the information analysis device 3, in regard to the plurality of processing information pieces transmitted from each substrate processing apparatus 1 to the information analysis device 3, a plurality of combinations each combination of which includes two different processing information pieces are predetermined.

Here, it is assumed that the substrate processing apparatus 1 is ideally operating in accordance with a predetermined processing procedure (recipe). In this case, a predetermined invariant relationship (hereinafter referred to as an invariant relationship) between two processing information pieces that form each combination is maintained.

On the other hand, it is assumed that an unintentional substrate process is executed because a substrate process is executed with an abnormality present in the substrate processing apparatus 1. In this case, at least the relationship between two processing information pieces forming one combination out of the plurality of combinations deviates from an invariant relationship.

The information analysis device 3 calculates a plurality of deviation degrees in regard to a plurality of pressing information pieces. A deviation degree indicates a degree of deviation from the predetermined invariant relationship between two processing information pieces to the relationship between two actually collected processing information pieces in regard to the two processing information pieces. Further, based on the plurality of calculated deviation degrees, the information analysis device 3 calculates a degree of abnormality of the substrate processing apparatus 1 as an abnormality score. The specific example of a method of calculating an abnormality score will be described below.

Further, as indicated by the thick one-dot and dash arrows in Fig. 1, the information analysis device 3 transmits a calculated abnormality score to each substrate processing apparatus 1. An abnormality score is transmitted each time an abnormality score is calculated in the information analysis device 3. At this time, each substrate processing apparatus 1 stores an abnormality score transmitted from the information analysis device 3.

Further, in regard to each substrate processing apparatus 1, the information analysis device 3 determines whether an abnormality score exceeds a predetermined first threshold value. In a case in which an abnormality score exceeds the first threshold value, the information analysis device 3 transmits a warning to the substrate processing apparatus 1 corresponding to the abnormality score. In the example of Fig. 1, as indicated by the wavy dotted arrows, the information analysis device 3 transmits a warnings to the substrate processing apparatus 1D, 1E out of the substrate processing apparatuses 1A to 1E. At this time, the substrate processing apparatus 1D, 1E that have received the warnings output warnings.

In the present embodiment, an abnormality that does not require quick maintenance by the maintenance worker has a lower abnormality score (degree of abnormality), and an abnormality that requires quick maintenance by the maintenance worker has a higher abnormality score (degree of abnormality). In case of a low abnormality score, it includes a case in which, it is predicted, based on the invariant relationships respectively corresponding to the plurality of above-mentioned combinations, that a plurality of processing conditions are in a normal range.

On the other hand, in case of a high abnormality score, it includes a state (hereinafter referred to as a first abnormal state) in which the temporal change of "a. CHEMICAL CONCENTRATION" is significantly larger than the temporal change of "a. CHEMICAL CONCENTRATION" that is predicted based on the temporal change of "b. SUPPLY AMOUNT OF CHEMICAL LIQUID," for example. When the first abnormal state continues, it causes a processing defect in the substrate W, generation of a harmful gas, and damage to a component of the substrate processing apparatus 1, due to the inability to adjust the chemical concentration of a cleaning liquid.

Further, in case of a high abnormal state, it includes a state (hereinafter referred to as a second abnormal state) in which a period of time from a point in time at which the concentration meter 20 is instructed to detect a concentration to a point in time at which the concentration meter 20 outputs a chemical concentration is significantly long. When the second abnormal state continues, it causes a processing defect in the substrate W, generation of a harmful gas, and damage to a component of the substrate processing apparatus 1, due to the inability to perform appropriate feedback control in regard to a chemical concentration.

Further, in case of a high abnormality score, it includes a state (hereinafter referred to as a third abnormal state) in which "f. POWER SUPPLIED TO MOTOR" is significantly larger than a predicted value, for example. In the third abnormal state, it is highly likely that an unexpected load is applied to the motor. Therefore, when the third abnormal state continues, it causes a failure in an operating portion including the motor, a failure in transport of the substrate Wand damage to the component of the substrate processing apparatus 1.

Further, in case of a high abnormality score, is includes a state (hereinafter referred to as a fourth abnormal state) in which "g. AMOUNT OF ADDITIONAL CHEMICAL LIQUID" varies beyond a predicted range, for example. In the fourth state, it is difficult to maintain a constant concentration of a cleaning liquid. Therefore, when the fourth abnormal state continues, it causes a processing failure in the substrate W.

Further, in case of a high abnormality score, it includes a state (hereinafter referred to as a fifth abnormal state) in which the temporal changes of "h. OPENING OF CHEMICAL LIQUID SUPPLY VALVE" and "i. OPENING OF CLEANING LIQUID DISCHARGE VALVE" are significantly different from the temporal changes of "h. OPENING OF CHEMICAL LIQUID SUPPLY VALVE" and "i. OPENING OF CLEANING LIQUID DISCHARGE VALVE" that are predicted based on "a. CHEMICAL CONCENTRATION" and "b. SUPPLY AMOUNT OF CHEMICAL LIQUID." In a case in which the substrate processing apparatus 1A is in the fifth abnormal state, it is considered that the substrate processing apparatus 1A is stopped by the emergency shutdown function or is to be inherently stopped.

### (5) Basic Operation in Management Device 4

The management device 4 is a personal computer, for example, and includes a CPU and a memory. Further, the management device 4 includes a display 4a and an operation unit 4b and is used by an administrator who manages a plurality of substrate processing apparatuses 1.

Each of a plurality of maintenance workers who are respectively in charge of the plurality of substrate processing apparatuses 1 can easily recognize a degree of abnormality of the substrate processing apparatus 1, which the maintenance worker is in charge of, by checking an abnormality score transmitted from the information analysis device 3. Further, each maintenance worker can recognize that a serious abnormality has occurred in the substrate processing apparatus 1, which the maintenance worker is in charge of, when the substrate processing apparatus 1 receives a warning.

However, even though being able to recognize the degree of abnormality of the substrate processing apparatus 1, each maintenance worker might not be able to specify the cause of the abnormality present in the substrate processing apparatus 1. In this case, the maintenance worker requests the administrator to inspect the substrate processing apparatus 1 in detail.

Thus, as indicated by the thick two-dot and dash arrows in Fig. 1, some (the substrate processing apparatuses 1A, 1C, 1E in the present example) or all of the plurality of substrate processing apparatuses 1 transmit inspection requests to the management device 4, for example. Further, as indicated by the thick dotted arrows in Fig. 1, abnormality scores are transmitted from one or a plurality of substrate processing apparatuses 1 (the substrate processing apparatuses 1A, 1C, 1E in the present example) that have transmitted the inspection requests to the management device 4.

Thus, even in a case in which receiving inspection requests from a plurality of substrate processing apparatuses 1 at the same time, for example, the management device 4 can easily and quickly determine the inspection priority order based on abnormality scores received together with the inspection requests. That is, the administrator can determine the inspection priority order based on the plurality of abnormality scores of the substrate processing apparatuses 1A, 1C, 1E which have made inspection requests.

In the management device 4, each of the inspection requests received from the one or plurality of substrate processing apparatuses 1 is excluded from being subject to determination of priority order each time the substrate processing apparatus 1 corresponding to the inspection request is inspected in detail.

### <2> Functional Configurations of Substrate Processing Apparatus Management System 2

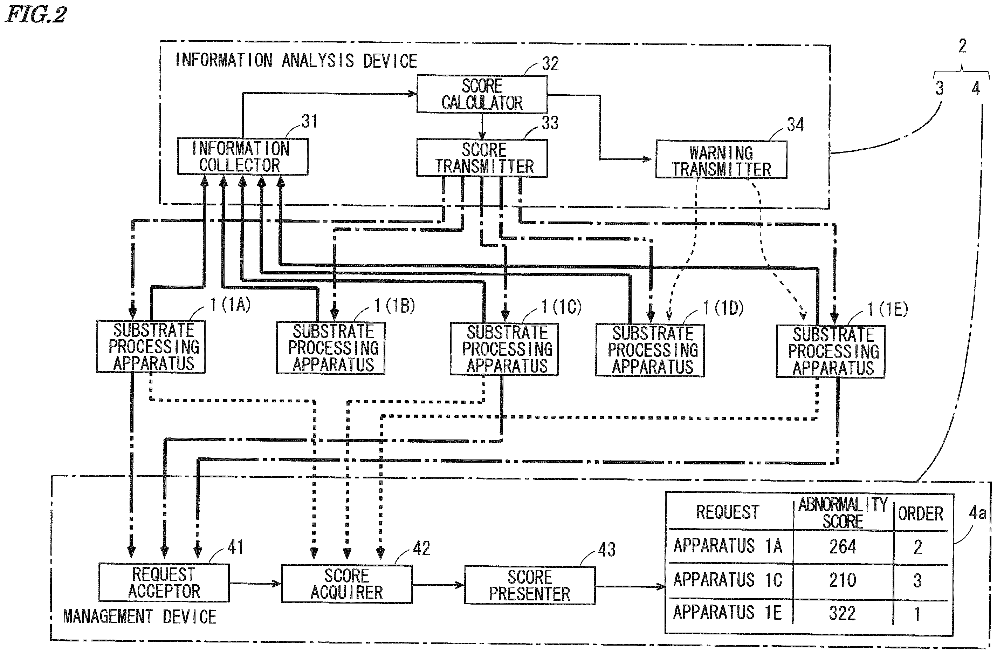

Fig. 2 is a block diagram for explaining the functional configuration of the substrate processing apparatus management system 2 according to the first embodiment. As shown in Fig. 2, the information analysis device 3 includes an information collector 31, a score calculator 32, a score transmitter 33 and a warning transmitter 34. The memory of the information analysis device 3 stores a second management program for managing the plurality of substrate processing apparatuses 1. The constituent elements (31 to 34) of the information analysis device 3 of Fig. 2 are implemented by execution of the second management program stored in the memory by the CPU of the information analysis device 3. Some or all of the constituent elements (31 to 34) of the information analysis device 3 may be realized by hardware such as an electronic circuit.

Further, the management device 4 includes a request acceptor 41, a score acquirer 42 and a score presenter 43. The memory of the management device 4 stores a third management program for managing the plurality of substrate processing apparatuses 1. The constituent elements (41 to 43) of the management device 4 of Fig. 2 are implemented by execution of the third management program stored in the memory by the CPU of the management device 4. Some or all of the constituent elements (41 to 43) of the management device 4 may be realized by hardware such as an electronic circuit.

As described above, a plurality of processing information pieces are transmitted from each of the plurality of substrate processing apparatuses 1 to the information analysis device 3 in a predetermined period (see the thick solid arrows in Fig. 2). The information collector 31 of the information analysis device 3 collects a plurality of processing information pieces transmitted from each substrate processing apparatus 1 and provides the plurality of processing information pieces to the score calculator 32.

The score calculator 32 of the information analysis device 3 calculates, based on the plurality of processing information pieces corresponding to the substrate processing apparatus 1, the abnormality score of each substrate processing apparatus 1, and provides the calculated abnormality score to the score transmitter 33 and the warning transmitter 34.

The score transmitter 33 of the information analysis device 3 transmits an abnormality score calculated by the score calculator 32 to the substrate processing apparatus 1 corresponding to the abnormality score (see the thick one-dot and dash arrows in Fig. 2). In each substrate processing apparatus 1, an abnormality score transmitted from the score transmitter 33 is stored while being associated with a point in time at which the abnormality score is calculated, a point in time at which the abnormality score is transmitted or a point in time at which the abnormality score is received, for example.

The warning transmitter 34 of the information analysis device 3 determines whether an abnormality score calculated in regard to each substrate processing apparatus 1 exceeds the above-mentioned first threshold value. Further, in a case in which the abnormality score exceeds the first threshold value, the warning transmitter 34 transmits a warning to the substrate processing apparatus 1 (the substrate processing apparatuses 1D, 1E in the example of Fig. 2) corresponding to the abnormality score (see the wavy dotted arrows of Fig. 2).

In each substrate processing apparatus 1, an inspection request in regard to an abnormality of the substrate processing apparatus 1 is transmitted to the management device 4 based on an operation by the maintenance worker. Further, the abnormality score stored in the substrate processing apparatus 1 is transmitted to the management device 4.

The request acceptor 41 of the management device 4 accepts an inspection request transmitted from the one or plurality of substrate processing apparatuses 1 (substrate processing apparatuses 1A, 1C, 1E in the example of Fig. 2) (see the thick two-dots and dash arrows of Fig. 2). The score acquirer 42 of the management device 4 acquires an abnormality score transmitted together with an inspection request from the one or plurality of substrate processing apparatuses 1 (the substrate processing apparatuses 1A, 1C, 1E in the example of Fig. 2) (see the thick dotted arrows of Fig. 2). The score presenter 43 of the management device 4 displays each of the one or plurality of abnormality scores acquired by the score acquirer 42 on the display 4a in association with the substrate processing apparatus 1 corresponding to an abnormality score.

In the example of Fig. 2, the abnormality scores of the substrate processing apparatuses 1A, 1C, 1E that have made the inspection requests are "264," "210" and "322," respectively. Thus, the administrator can easily recognize the degrees of abnormality of the substrate processing apparatuses 1E, 1A, 1C. Further, the administrator can find out that she or he is simply required to inspect the substrate processing apparatuses 1E, 1A, 1C in detail in this order.

In a case in which a plurality of abnormality scores are calculated in regard to a plurality of uninspected substrate processing apparatuses 1 that have transmitted inspection requests, the score presenter 43 may determine the inspection priority order based on these abnormality scores and cause the display 4a to display the determined priority order.

### <3> Specific Example of Calculation of Abnormality Score

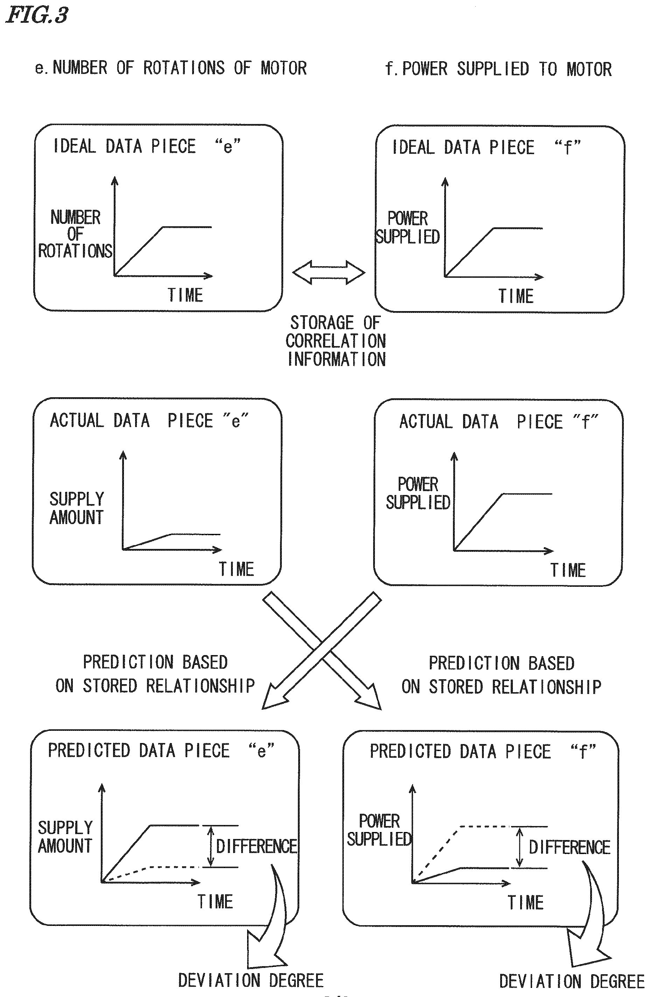

As described above, in the substrate processing apparatus management system 2, a plurality of combinations each of which includes two different processing information pieces are defined. In order to calculate an abnormality score, a deviation degree is calculated for each combination. Fig. 3 is a diagram for explaining the specific example of calculation of a deviation degree. Here, the example of calculation of a deviation degree corresponding to the combination of "b. NUMBER OF ROTATIONS OF MOTOR" and "f. POWER SUPPLIED TO MOTOR" of Fig. 1 is described. In the following description, the data of "e. NUMBER OF ROTATIONS OF MOTOR" is suitably referred to as a data piece "e," and the data of "f. POWER SUPPLIED TO MOTOR" is suitably referred to as a data piece "f."

In order to calculate the deviation degree, reference data based on the invariant relationship between "e. NUMBER OF ROTATIONS OF MOTOR" and "b. POWER SUPPLIED TO MOTOR" is required. As such, before a process is actually executed on a substrate W in each substrate processing apparatus 1, the information analysis device 3 holds a data piece "e" and a data piece "f" obtained when the substrate processing apparatus 1 is ideally operating (normally operating) in accordance with a recipe.

These ideal data piece "e" and ideal data piece "f" are acquired based on a plurality of processing information pieces transmitted from each substrate processing apparatus 1 when the substrate processing apparatus 1 is operating actually and normally, for example. Alternatively, the ideal data piece "e" and the ideal data piece "f" may be generated by simulation or the like.

In the upper portion of Fig. 3, one example of the temporal changes of an ideal data piece "e" and an ideal data piece "f" is shown by graphs. In the graph for the data piece "e," the abscissa indicates time, and the ordinate indicates the number of rotations of the motor. In the graph of the data piece "f," the abscissa indicates time, and the ordinate indicates an amount of power supplied to the motor provided in the lifting-lowering device 13 of Fig. 1. The abscissa (time axis) is common between the graph for the data piece "e" and the graph for the data piece "f."

According to the two graphs in the upper portion of Fig. 3, it is found that the power supplied to the motor increases at a substantially constant rate as the number of rotations of the motor increases. These relationships are maintained invariant under the condition that the substrate processing apparatus 1 operates ideally. As such, the information analysis device 3 stores these relationships (invariant relationships) in advance as correlation information.

In this state, a process is executed on a substrate W in each substrate processing apparatus 1, and an actual data piece "e" and an actual data piece "f" are collected by the information collector 31 of the information analysis device 3. In the center portion of Fig. 3, one example of the temporal changes of an actually collected data piece "e" and an actually collected data piece "f" is shown by the graphs.

When the actual data piece "e" is collected, the score calculator 32 predicts a data piece "f" based on the correlation information stored in advance. Further, when the actual data piece "f" is collected, the score calculator 32 predicts a data piece "e" based on the correlation information stored in advance. In the lower portion of Fig. 3, one example of the temporal changes of the data piece "e" and the data piece "f" that are predicted based on the correlation information is shown by the graphs. In the graphs in the lower portion of Fig. 3, the predicted data piece "e" and the predicted data piece "f" are indicated by the solid lines, and the actually collected data piece "e" and the actually collected data piece "f" are indicated by the dotted lines.

In a case in which the substrate processing apparatus 1 is ideally operating, the actual data piece "e" and the predicted data piece "e" coincide or substantially coincide with each other. Further, the actual data piece "f" and the predicted data piece "f" coincide or substantially coincide with each other. However, in a case in which an abnormality is present in the substrate processing apparatus 1, the actual data piece "e" and the predicted data piece "e" are likely to deviate from each other. The actual data piece "f" and the predicted data piece "f" are also likely to deviate from each other. It is considered that, the larger a degree of abnormality that occurs in the substrate processing apparatus 1, the larger a degree of deviation, and the smaller a degree of abnormality that occurs in the substrate processing apparatus 1, the smaller a degree of deviation.

As such, in the present embodiment, the difference value between the data representing an actually collected processing information piece and the data representing a predicted processing information piece is calculated as a deviation degree. In the example of Fig. 3, the score calculator 32 calculates the difference value between the actual data piece "e" and the predicted data piece "e" as a deviation degree when calculating a deviation degree at a certain point in time. Further, the score calculator 32 calculates the difference value between the actual data piece "f" and the predicted data piece "f" as a deviation degree.

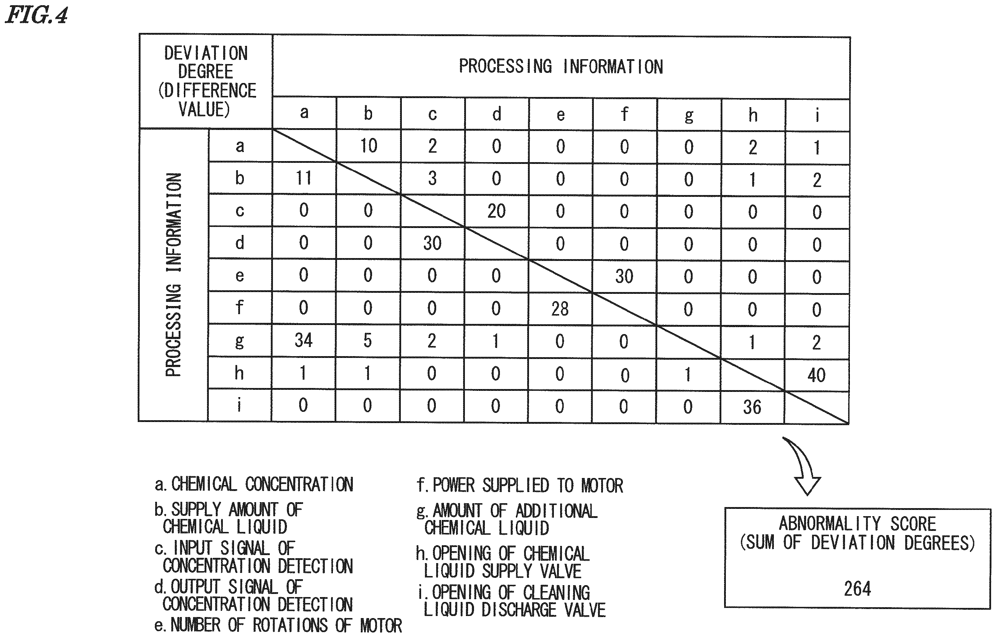

Fig. 4 is a diagram for explaining the specific example of calculation of an abnormality score. The score calculator 32 calculates the above-mentioned deviation degrees for all combinations in regard to a plurality of processing information pieces. Fig. 4 shows a plurality of deviation degrees calculated for all combinations in regard to the plurality of processing information pieces. When all of the deviation degrees are calculated, the score calculator 32 calculates the sum of the plurality of calculated deviation degrees as an abnormality score.

### <4> Series of Processes Executed in Each of Plurality of Substrate Processing Apparatuses 1

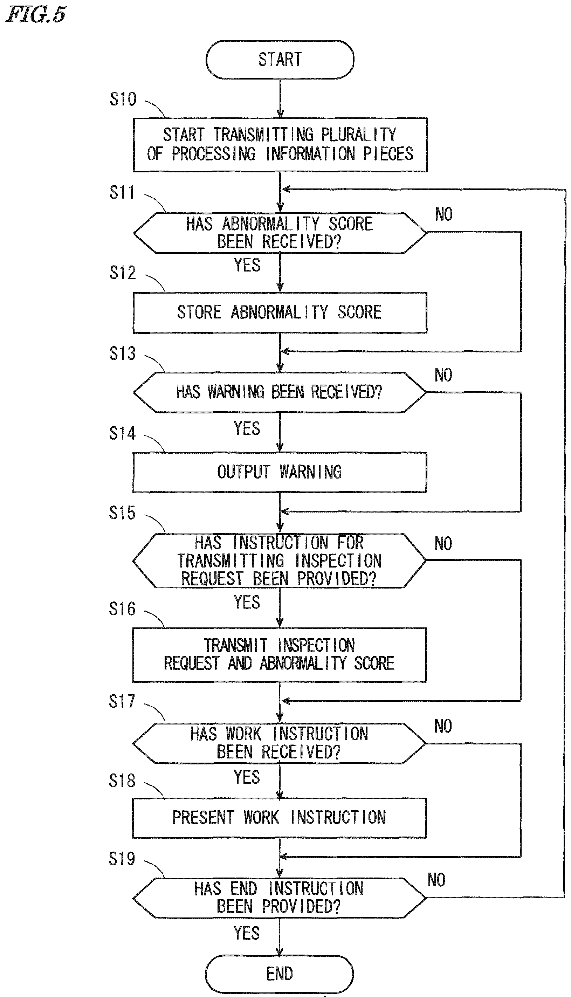

Fig. 5 is a flowchart showing one example of the processes executed in each of the plurality of substrate processing apparatuses 1 of Fig. 1. The series of processes shown in Fig. 5 is started when the power of each substrate processing apparatus 1 is turned on, and the CPU of the control device 40 executes the first management program.

First, the control device 40 transmits a plurality of processing information pieces acquired in the substrate processing apparatus 1 to the information analysis device 3 in a predetermined period (step S10). The process of transmitting the plurality of processing information pieces started in the step S10 is repeated in the predetermined period until the power of the substrate processing apparatus 1 is turned off. When transmitting the plurality of processing information pieces, the control device 40 may store the plurality of transmitted processing information pieces in association with the points in time at which the plurality of processing information pieces are transmitted.

Next, the control device 40 determines whether an abnormality score has been received from the information analysis device 3 (step S11). In a case in which not receiving an abnormality score, the control device 40 proceeds to the process of the step S13, described below. On the other hand, in a case in which receiving an abnormality score, the control device 40 stores the received abnormality score in association with the point in time at which the abnormality score is received (step S12).

Next, the control device 40 determines whether a warning has been received from the information analysis device 3 (step S13). In a case in which not receiving a warning, the control device 40 proceeds to the process of the step S15, described below. On the other hand, in a case in which receiving a warning, the control device 100 outputs a warning using the display device or the speech output device of the substrate processing apparatus 1 (step S14). The above-mentioned steps S11 and S12 may be performed after the step S14.

Next, the control device 40 determines whether an instruction for transmitting an inspection request to the management device 4 has been received (step S15). An instruction for transmitting an inspection request is provided to the control device 40 when a maintenance worker operates the operation unit of the substrate processing apparatus 1, for example. In a case in which not receiving an instruction for transmitting an inspection request, the control device 40 proceeds to the step S17, described below. On the other hand, in a case in which receiving an instruction for transmitting an inspection request, the control device 40 transmits an inspection request and an abnormality score stored at a point in time closest to the current point in time to the management device 4 (step S16). In the step S16, the control device 40 may transmit a plurality of abnormality scores stored in a predetermined period of time (several hours, for example) from a current point in time to the management device 4 together with the points in time at which the plurality of abnormality scores are received.

Next, the control device 40 determines whether a work instruction for performing a specific work on the substrate processing apparatus 1 has been received from the management device 4 (step S17). In a case in which not receiving a work instruction, the control device 40 proceeds to the step S19, described below. On the other hand, in a case in which receiving a work instruction, the control device 40 presents the received work instruction to a maintenance worker using the display device included in the substrate processing apparatus 1, for example (step S18).

Thereafter, the control device 40 determines whether an end instruction for stopping an operation of the substrate processing apparatus 1 has been received (step S19). In a case in which not receiving an end instruction, the control device 40 proceeds to the step S11. On the other hand, when receiving an end instruction, the control device 40 ends the series of processes.

### <5> Series of Processes Executed in Information Analysis Device 3

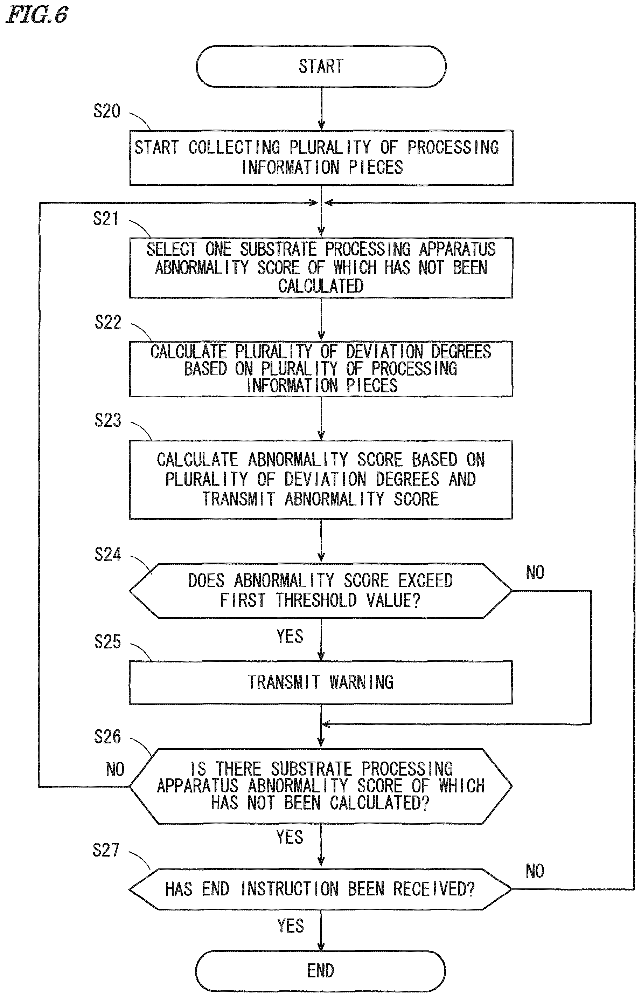

Fig. 6 is a flowchart showing one example of the processes executed in the information analysis device 3 of Fig. 1. The series of processes shown in Fig. 6 is started when the power of the information analysis device 3 is turned on, and the CPU of the information analysis device 3 executes the second management program.

First, the information collector 31 of Fig. 2 starts collecting a plurality of processing information pieces transmitted from each of a plurality of substrate processing apparatuses 1 (step S20). The process of transmitting the plurality of processing information pieces started in the step S20 is repeated in a predetermined period until the power of the information analysis device 3 is turned off.

Next, the score calculator 32 of Fig. 2 selects one substrate processing apparatus 1 the abnormality score of which has not been calculated among one or a plurality of substrate processing apparatuses 1 from which the plurality of processing information pieces are collected in the step S20 (step S21).

Next, the score calculator 32 calculates a plurality of deviation degrees based on the plurality of collected processing information pieces in regard to the one selected substrate processing apparatus 1 (step S22). Further, the score calculator 32 calculates an abnormality score of the one substrate processing apparatus 1 based on the plurality of calculated deviation degrees, and transmits the calculated abnormality score to the one substrate processing apparatus 1 (step S23).

Next, the warning transmitter 34 of Fig. 2 determines whether the abnormality score calculated in the step S23 exceeds the first threshold value (step S24). In a case in which the abnormality score does not exceed the first threshold value, the warning transmitter 34 proceeds to the step S26, described below. On the other hand, in a case in which the abnormality score exceeds the first threshold value, the warning transmitter 34 transmits a warning to the one substrate processing apparatus 1 (step S25).

Next, the score calculator 32 determines whether there is a substrate processing apparatus 1 from which a plurality of processing information pieces have been collected and the abnormality score of which has not been calculated (step S26). In a case in which there is a substrate processing apparatus 1 the abnormality score of which has not been calculated, the score calculator 32 proceeds to the step S21. On the other hand, in a case in which there is no substrate processing apparatus 1 the abnormality score of which has not been calculated, the score calculator 32 determines whether an end instruction for stopping the operation of the information analysis device 3 has been received (step S27). In a case in which not receiving an end instruction, the score calculator 32 proceeds to the step S21. On the other hand, when receiving an end instruction, the score calculator 32 ends the series of processes.

### <6> Series of Processes Executed in Management Device 4

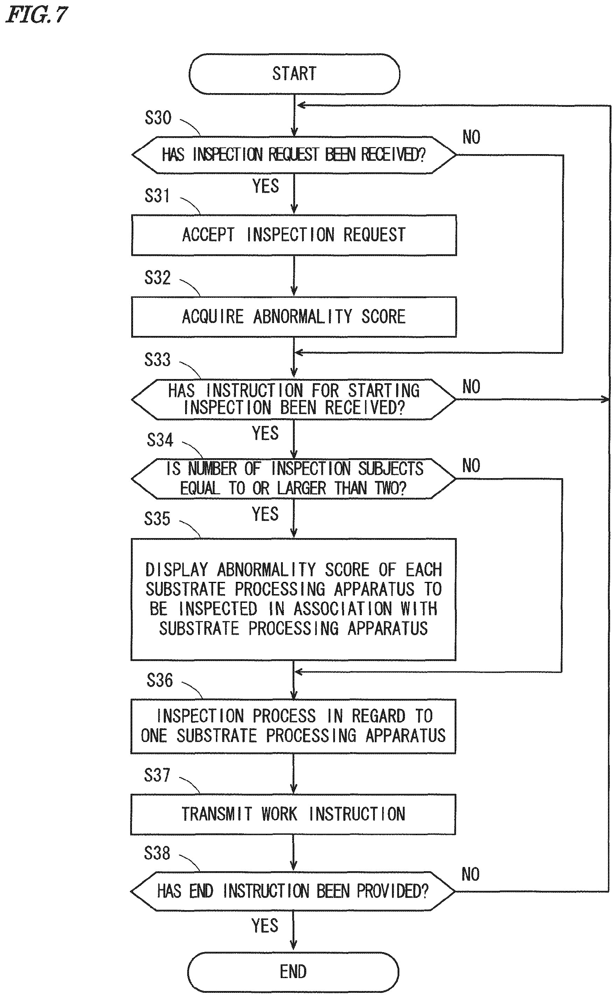

Fig. 7 is a flowchart showing one example of the processes executed in the management device 4 of Fig. 1. The series of processes shown in Fig. 7 is started when the power of the management device 4 is turned on, and the CPU of the management device 4 executes the third management program.

First, the request acceptor 41 of Fig. 2 determines whether an inspection request has been received from at least one substrate processing apparatus 1 among the plurality of substrate processing apparatuses 1 (step S30). In a case in which not receiving an inspection instruction, the request acceptor 41 proceeds to the step S33, described below. On the other hand, in a case in which receiving an inspection request from the at least one substrate processing apparatus 1, the request acceptor 41 accepts the received inspection request (step S31).

As described above, when transmitting an inspection request to the management device 4, the substrate processing apparatus 1 transmits an abnormality score together with the inspection request to the management device 4. Thus, the score acquirer 42 of Fig. 2 receives and acquires the abnormality score transmitted together with the inspection request (step S32). The inspection request and the abnormality score that are acquired then are stored in the memory of the management device 4.

Next, the score presenter 43 of Fig. 2 determines whether an instruction for starting inspection of the substrate processing apparatus has been received (step S33). An instruction for starting inspection is provided to the score presenter 43 when the administrator operates the operation unit 4b of the management device 4, for example. In a case in which not receiving an instruction for starting inspection, the score presenter 43 proceeds to the step S30. On the other hand, in a case in which receiving an instruction for starting inspection, the score presenter 43 determines whether the number of substrate processing apparatuses 1 to be inspected is equal to or larger than 2 (step S34).

In a case in which the number of substrate processing apparatuses 1 to be inspected is one, the score presenter 43 proceeds to the step S36, described below. On the other hand, in a case in which the number of substrate processing apparatuses 1 to be inspected (uninspected substrate processing apparatuses 1) is equal to or larger than 2, the score presenter 43 displays the abnormality score of each substrate processing apparatus 1 to be inspected on the display 4a in association with the substrate processing apparatus 1 (step S35). In a case in which the number of substrate processing apparatuses 1 to be inspected is one, the score presenter 43 may display the abnormality score of the substrate processing apparatus 1 on the display 4a. Further, the score presenter 43 may determine the inspection priority order based on the plurality of abnormality scores in regard to the plurality of uninspected substrate processing apparatuses 1 the inspection requests of which have been received. In this case, the score presenter 43 may display the determined priority order on the display 4a.

Thereafter, in response to an operation performed by the administrator on the operation unit 4b, the CPU of the management device 4 performs an inspection process on one substrate processing apparatus 1 among the one or plurality of substrate processing apparatuses 1 to be inspected (step S36). Further, the CPU of the management device 4 transmits a work instruction for the maintenance worker to the one substrate processing apparatus 1 based on a result of the inspection process (step S37).

Next, the CPU of the management device 4 determines whether an end instruction for stopping the operation of the management device 4 has been received (step S38). In a case in which not receiving an end instruction, the CPU of the management device 4 proceeds to the step S30. On the other hand, when receiving an end instruction, the CPU of the management device 4 ends the series of processes.

In the step S36, the inspection request and the abnormality score in regard to the substrate processing apparatus 1 on which the inspection process has been performed are deleted from the memory of the management device 4 when the inspection process ends. Alternatively, in the step S36, a substrate processing apparatus 1 on which the inspection process has been performed is excluded from the candidates that are subject to inspection.

Further, in the step S38, in a case in which an uninspected substrate processing apparatus 1 is present among the one or plurality of substrate processing apparatuses 1 to be inspected, the inspection request is held while being stored in the memory of the management device 4. Alternatively, in the step S38, a substrate processing apparatus 1 which is to be inspected and on which the inspection process has not been performed remains as a candidate that is subject to inspection.

### <7> Effects of First Embodiment

In the management device 4, in a case in which two or more inspection requests have been made for two or more substrate processing apparatuses 1, the degrees of abnormality of the two or more substrate processing apparatuses 1 that have transmitted the inspection requests are displayed on the display 4a as abnormality scores. In this case, based on the displayed abnormality scores, the administrator can easily recognize the degrees of abnormality of the two or more substrate processing apparatuses 1 that have transmitted the inspection requests. Further, the abnormality scores are calculated based on the invariant relationships in regard to a plurality of processing information pieces. Therefore, in regard to a plurality of substrate processing apparatuses 1 that have transmitted inspection requests, the administrator can easily and appropriately recognize the inspection priority order in a short period of time.

Further, in the above-mentioned substrate processing apparatus management system 2, an abnormality score calculated in the information analysis device 3 is transmitted to the substrate processing apparatus 1 corresponding to the abnormality score. In each substrate processing apparatus 1, the abnormality scores corresponding to the substrate processing apparatus 1 are stored in a chronological order. Thus, the maintenance worker in charge of each substrate processing apparatus 1 can easily check the temporal change of the abnormality scores stored in the substrate processing apparatus 1.

### 2. Second Embodiment

Among the plurality of combinations in regard to the plurality of above-mentioned processing information pieces, in a case in which the degree of abnormality of the substrate processing apparatus 1 is recognized, there are combinations to be particularly prioritized and combinations that do not need to be prioritized.

For example, in consideration of the first abnormal state, the combination of "a. CHEMICAL CONCENTRATION" and "b. SUPPLY AMOUNT OF CHEMICAL LIQUID" has high relevance to calculation of an abnormality score in order to avoid continuation of the first abnormal state. Further, in consideration of the second abnormal state, it can be said that the combination of "c. INPUT SIGNAL OF CONCENTRATION DETECTION" and "d. OUTPUT SIGNAL OF CONCENTRATION DETECTION" has high relevance to calculation of an abnormality score in order to avoid continuation of the second abnormal state. On the other hand, it can be said that the combination of processing information pieces for which it is not necessary to consider any of the first abnormal state to the fifth abnormal state has low relevance to calculation of an abnormality score.

In the substrate processing apparatus management system 2 according to the first embodiment, a deviation degree is the difference value between the data of an actually collected processing information piece and the data of a predicted processing information piece. Therefore, in regard to the deviation degree calculated in the above-mentioned embodiment, a plurality of types of abnormal states of the substrate processing apparatus 1 that are to be inherently prioritized when an abnormality score is calculated are not taken into consideration. As such, the substrate processing apparatus management system according to the second embodiment has the following configuration.

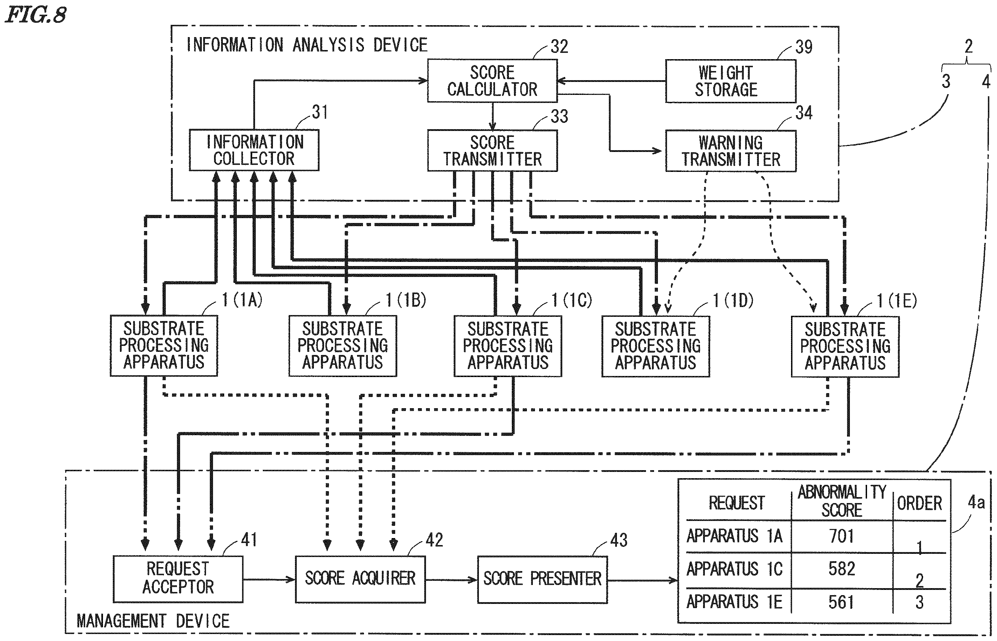

Differences of the substrate processing apparatus management system according to the second embodiment from the substrate processing apparatus management system 2 of Fig. 2 according to the first embodiment will be described. Fig. 8 is a diagram for explaining the functional configuration of the substrate processing apparatus management system according to the second embodiment. As shown in Fig. 8, in the substrate processing apparatus management system 2 according to the present embodiment, an information analysis device 3 includes, as a function, a weight storage 39 in addition to the constituent elements (31 to 34) described in the first embodiment. The weight storage 39 is implemented by execution of a second management program stored in the memory by the CPU of an information analysis device 3 according to the second embodiment. The weight storage 39 may be realized by hardware such as an electronic circuit.

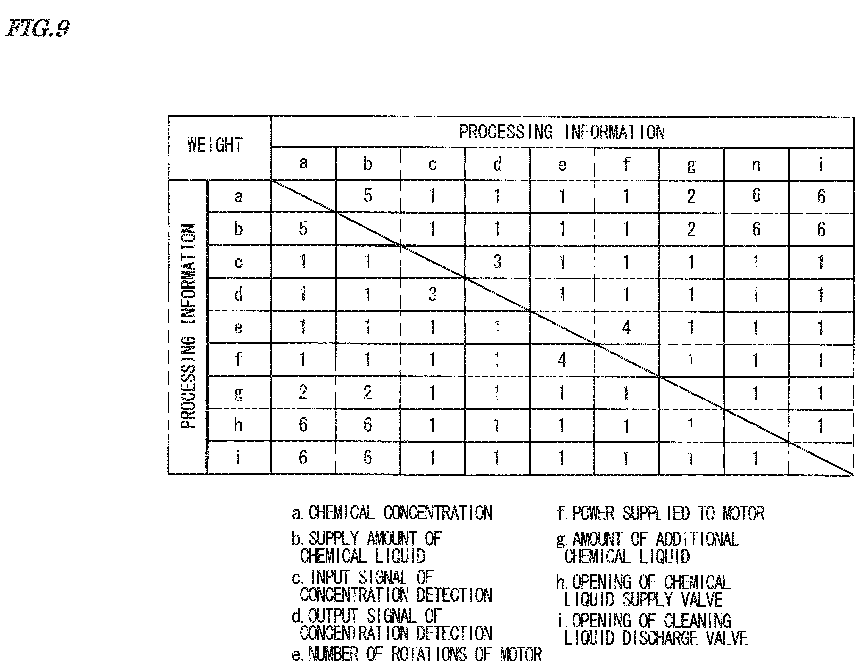

The weight storage 39 stores a plurality of weights corresponding to a plurality of combinations in regard to a plurality of processing information pieces. Fig. 9 is a diagram showing one example of the plurality of weights stored in the weight storage 39 of Fig. 8. In the present embodiment, six abnormality levels of a "first level" to a "sixth level" are set in regard to a plurality of types of abnormal states that may occur in the substrate processing apparatus 1. In regard to the six abnormality levels, the "first level" has the lowest degree of abnormality, the "second level" has the fifth highest degree of abnormality, the "third level" has the fourth highest degree of abnormality, the "fourth level" has the third highest degree of abnormality, the "fifth level" has the second highest degree of abnormality, and the "sixth level" has the highest degree of abnormality. Further, to a combination of processing information pieces that has high relevance to each abnormal state, the weight having the magnitude corresponding to the abnormality level of the abnormal state is assigned.

Specifically, the "sixth level" having the highest degree of abnormality is set for the fifth abnormal state. Then, a weight "6" is assigned to the combinations (eight combinations) in regard to "a. CHEMICAL CONCENTRATION," "b. SUPPLY AMOUNT OF CHEMICAL LIQUID," "h. OPENING OF CHEMICAL LIQUID SUPPLY VALVE" and "I. OPENING OF CLEANING LIQUID DISCHARGE VALVE" which have high relevance to the fifth abnormal state.

Further, the "fifth level" having the second highest degree of abnormality is set for the first abnormal state. Then, a weight "5" is assigned to the combinations (two combinations) in regard to "a. CHEMICAL CONCENTRATION" and "b. SUPPLY AMOUNT OF CHEMICAL LIQUID," which have high relevance to the first abnormal state.

Further, the "fourth level" having the third highest degree of abnormality is set for the third abnormal state. Then, a weight "4" is assigned to the combinations (two combinations) in regard to "e. NUMBER OF ROTATIONS OF MOTOR" and "f. POWER SUPPLIED TO MOTOR," which have high relevance to the third abnormal state.

Further, the "third level" having the fourth highest degree of abnormality is set for the second abnormal state. Then, a weight "3" is assigned to the combinations (two combinations) in regard to "c. INPUT SIGNAL OF CONCENTRATION DETECTION" and "D. OUTPUT SIGNAL OF CONCENTRATION DETECTION," which have high relevance to the second abnormal state.

Further, the "second level" having the fifth highest degree of abnormality is set for the fourth abnormal state. Then, a weight "2" is assigned to the combinations (four combinations) in regard to "a. CHEMICAL CONCENTRATION," "b. SUPPLY AMOUNT OF CHEMICAL LIQUID" and "g. AMOUNT OF ADDITIONAL CHEMICAL LIQUID," which have high relevance to the fourth abnormal state.

Further, the "first level" having the lowest degree of abnormality is set for an abnormal state other than the first to fifth abnormal states. Then, a weight "1" is assigned to the combinations in regard to a plurality of processing information pieces which have low relevance to a plurality of abnormal states including the first to fifth abnormal states.

Similarly to the score calculator 32 of Fig. 2, the score calculator 32 of Fig. 8 calculates the difference value between the data of an actually collected processing information piece and the data of a predicted processing information piece for each of a plurality of combinations in regard to a plurality of processing information pieces. Further, for each combination in regard to a plurality of processing information pieces, the score calculator 32 of Fig. 8 calculates a value (multiplication value) obtained when the calculated difference value is multiplied by the weight assigned to the combination as a deviation degree, based on the plurality of weights stored in the weight storage 39. Further, when all of the deviation degrees are calculated, the score calculator 32 of Fig. 8 calculates the sum of the plurality of calculated deviation degrees as an abnormality score.

In this manner, in the substrate processing apparatus management system 2 according to the second embodiment, an abnormality score is calculated based on deviation degrees respectively including weight components respectively corresponding to abnormality levels. Thus, the administrator of the plurality of substrate processing apparatuses 1 can more appropriately recognize the degree of abnormality of each substrate processing apparatus 1 by referring to the calculated abnormality score.

### 3. Other Embodiments

(1) In the substrate processing apparatus management system 2 according to the above-mentioned embodiment, the information collector 31 may repeat integration and reset of collected processing information pieces each time a predetermined period of time elapses. Further, the information collector 31 may provide the processing information pieces that are integrated until immediately before the reset to the score calculator 32 each time a predetermined period of time elapses. In this case, the score calculator 32 calculates an abnormality score based on the plurality of integrated processing information pieces. In this case, it suppresses the influence of a noise or the like generated when each processing information piece is collected on an abnormality score.
(2) In the substrate processing apparatus management system 2 according to the above-mentioned embodiment, the series of processes executed in the information analysis device 3 may be executed in the management device 4. Further, the series of processes executed in the information analysis device 3 may be executed in any one of the plurality of substrate processing apparatuses 1. In this case, the information analysis device 3 is not required.
(3) In the substrate processing apparatus management system 2 according to the above-mentioned embodiment, the information analysis device 3 may receive inspection requests from the plurality of substrate processing apparatuses and transmit the received inspection requests and the abnormality scores corresponding to the inspection requests to the management device 4.
(4) In the substrate processing apparatus management system 2 according to the above-mentioned embodiment, abnormality scores do not have to be transmitted from the information analysis device 3 to the plurality of substrate processing apparatuses 1. In this case, the management device 4 that has received an inspection request from any one of the plurality of substrate processing apparatuses 1 may acquire the abnormality score of the substrate processing apparatus 1 that has transmitted the inspection request from the information analysis device 3.
(5) While the plurality of substrate processing apparatuses 1A to 1E have the same configuration in the above-mentioned embodiment, the present invention is not limited to this. Some or all of the plurality of substrate processing apparatuses 1A to 1E may have different configurations. Further, at least one of the plurality of substrate processing apparatuses 1A to 1E of Fig. 1 may be a single-wafer substrate cleaning device instead of a batch substrate cleaning device, or may have a configuration for executing a process other than a cleaning process.
(6) In addition to or instead of the plurality of specific examples described in the above-mentioned embodiment, a plurality of processing information pieces may include at least one physical quantity from among a temperature of fluid supplied to a substrate W, a temperature in a processing chamber in which the substrate W is accommodated, a pressure in the processing chamber in which the substrate W is accommodated, a pressure of gas exhausted from the processing chamber in which the substrate W is accommodated, and a moving speed of the substrate transported by a robot.
   Further, the plurality of processing information pieces may include information in regard to at least one of a drive pulse signal for driving a robot that transports the substrate W and an output signal of a detector provided in the robot that transports the substrate W.
(7) In the substrate processing apparatus management system 2 according to the above-mentioned embodiment, the score calculator 32 may further calculate an integrated value of abnormality scores by repeating integration and reset of abnormality scores each time a predetermined period of time elapses. In this case, the warning transmitter 34 may determine whether the integrated value of the abnormality scores exceeds a predetermined second threshold value. In a case in which an integrated value of abnormality scores exceeds the second threshold value, the warning transmitter 34 may transmit a warning to the substrate processing apparatus 1 corresponding to the integrated value of the abnormality scores. In this case, the maintenance worker of each substrate processing apparatus 1 can recognize an occurrence of an abnormality in the substrate processing apparatus 1, which the maintenance worker is in charge of, with higher accuracy.

### 4. Correspondences Between Constituent Elements in Claims and Parts in Preferred Embodiments

In the following paragraphs, non-limiting examples of correspondences between various elements recited in the claims below and those described above with respect to various preferred embodiments of the present disclosure are explained. As each of various elements recited in the claims, various other elements having configurations or functions described in the claims can be also used.

In the above-mentioned embodiment, the substrate processing apparatuses 1, 1A to 1E are an example of a plurality of substrate processing apparatuses, the substrate processing apparatus management system 2 is an example of a substrate processing apparatus management system, the information collector 31 is an example of an information collector, the score calculator 32 is an example of a score calculator, and the request acceptor 41 is an example of a request acceptor.

Further, the score acquirer 42 is an example of a score acquirer, the score presenter 43 is an example of a priority order presenter, the plurality of abnormality scores and the inspection priority order of the plurality of substrate processing apparatuses 1 are examples of priority order information pieces, the score transmitter 33 is an example of a score transmitter, the warning transmitter 34 is an example of a warning transmitter, and the information analysis device 3 is an example of an information analysis device.

## Claims

1. A substrate processing apparatus management system that is used to manage a plurality of substrate processing apparatuses, comprising:
an information collector that collects a plurality of processing information pieces representing operations or states relating to a process for a substrate from each substrate processing apparatus;
a score calculator that, in regard to each substrate processing apparatus, calculates a degree of abnormality of the substrate processing apparatus as an abnormality score based on a plurality of processing information pieces collected from the substrate processing apparatus and invariant relationships in regard to the plurality of processing information pieces;
a request acceptor that accepts an inspection request in regard to an abnormality from each substrate processing apparatus;
a score acquirer that acquires two or more abnormality scores respectively calculated in regard to two or more substrate processing apparatuses that have transmitted inspection requests to the request acceptor; and
a priority order presenter that, based on the two or more abnormality scores acquired by the score acquirer, presents priority order information relating to priority order for the two or more inspection requests to be responded.

2. The substrate processing apparatus management system according to claim 1, wherein
the priority order information includes the two or more abnormality scores acquired by the score acquirer, and
the priority order presenter presents the two or more respective abnormality scores acquired by the score acquirer in association with the two or more respective substrate processing apparatuses.

3. The substrate processing apparatus management system according to claim 1 or 2, further comprising:
a score transmitter that transmits an abnormality score calculated by the score calculator to a substrate processing apparatus corresponding to the abnormality score.

4. The substrate processing apparatus management system according to any one of claims 1 to 3, further comprising a warning transmitter that determines whether an abnormality score calculated in regard to each substrate processing apparatus exceeds a predetermined threshold value, and in a case in which the abnormality score exceeds the threshold value, transmits a warning to a substrate processing apparatus corresponding to the abnormality score.

5. The substrate processing apparatus according to any one of claims 1 to 4, wherein
the information collector repeats integration and reset of a plurality of processing information pieces that are calculated each time a certain period of time elapses, and
the score calculator, in regard to each substrate processing apparatus, calculates a degree of abnormality of the substrate processing apparatus as the abnormality score based on a plurality of processing information pieces that are generated by the substrate processing apparatus and integrated by the information collector and invariant relationships in regard to the plurality of processing information pieces.

6. The substrate processing apparatus management system according to any one of claims 1 to 5, wherein
in regard to the plurality of processing information pieces, a plurality of combinations each of which includes two different processing information pieces are defined,
each combination includes a first processing information piece and a second information piece, and
the score calculator,
in regard to each combination, generates, based on the second processing information piece that is collected under a predetermined condition, the first processing information piece that is predicted under the predetermined condition as a first prediction processing information piece, and calculates a degree of deviation between the generated first prediction processing information piece and the first processing information piece actually collected by the data collector as a first deviation degree,
in regard to each combination, generates, based on the first processing information piece that is collected under the predetermined condition, the second processing information that is predicted under the predetermined condition as a second prediction processing information piece, and calculates a degree of deviation between the generated second prediction processing information piece and the second processing information piece that is actually collected by the data collector as a second deviation degree, and
calculates the abnormality score based on a plurality of first deviation degrees and a plurality of second deviation degrees that are respectively calculated in regard to the plurality of combinations.

7. The substrate processing apparatus management system according to claim 6, wherein
the score calculator calculates a sum of the plurality of first deviation degrees and the plurality of second deviation degrees that are respectively calculated in regard to the plurality of combinations as the abnormality score.

8. The substrate processing apparatus management system according to claim 6 or 7, wherein
a predetermined weight is assigned to each of the plurality of combinations according to relevance of the combination to a plurality of types of abnormal states of a substrate processing apparatus, and
the score calculator calculates the plurality of first deviation degrees and the plurality of second deviation degrees based on the plurality of combinations and the plurality of weights.

9. The substrate processing apparatus management system according to any one of claims 1 to 8, wherein
the plurality of processing information pieces include at least one physical quantity among an amount of fluid supplied to a substrate, a temperature of fluid supplied to the substrate, a concentration of a processing liquid supplied to the substrate, a temperature in a processing chamber in which the substrate is accommodated, a pressure in the processing chamber in which the substrate is accommodated, a pressure of gas exhausted from the processing chamber in which the substrate is accommodated and a moving speed of the substrate transported by a robot.

10. The substrate processing apparatus management system according to any one of claims 1 to 9, wherein
the plurality of processing information pieces include information relating to at least one of a drive pulse signal that drives a robot transporting a substrate, an output signal of a detector provided in the robot transporting the substrate and an open-close signal provided to a control valve.

11. The substrate processing apparatus management system according to any one of claims 1 to 10, wherein
each substrate processing apparatus is a substrate cleaning device that cleans a substrate using a cleaning liquid, and
the plurality of processing information pieces include at least one of a supply amount of the cleaning liquid supplied to the substrate, a temperature of the cleaning liquid supplied to the substrate and a concentration of the cleaning liquid supplied to the substrate.

12. A substrate processing apparatus management method that is used for management of a plurality of substrate processing apparatuses, including the steps of:
collecting a plurality of processing information pieces representing operations or states relating to a process for a substrate from each substrate processing apparatus;
in regard to each substrate processing apparatus, calculating a degree of abnormality of the substrate processing apparatus as an abnormality score based on a plurality of processing information pieces collected from the substrate processing apparatus and invariant relationships in regard to the plurality of substrate processing information pieces;
accepting an inspection request in regard to an abnormality from each substrate processing apparatus;
acquiring two or more abnormality scores respectively calculated in regard to two or more substrate processing apparatuses that have transmitted inspection requests; and
based on the two or more abnormality scores acquired by the score acquirer, presenting priority order information relating to priority order for the two or more inspection requests to be responded.

13. A substrate processing apparatus management program for causing a computer to execute a process of managing a plurality of substrate processing apparatuses using an information analysis device,
the information analysis device including:
an information collector that collects a plurality of processing information pieces representing operations or states relating to a process for a substrate from each substrate processing apparatus; and
a score calculator that, in regard to each substrate processing apparatus, calculates a degree of abnormality of the substrate processing apparatus as an abnormality score based on a plurality of processing information pieces collected from the substrate processing apparatus and invariant relationships in regard to the plurality of processing information pieces;
the process of managing a plurality of substrate processing apparatuses including:
accepting an inspection request in regard to an abnormality from each substrate processing apparatus;
acquiring two or more abnormality scores respectively calculated in regard to two or more substrate processing apparatuses that have transmitted inspection requests; and
based on the two or more abnormality scores acquired by the acquiring, presenting priority order information relating to priority order for the two or more inspection requests to be responded.
